# EUROPEAN PATENT SPECIFICATION

(11) **EP 4 481 417 B1**
(45) Date of publication and mention of the grant of the patent: **23.09.2026**
(21) Application number: 23799524.6
(22) Date of filing: 27.01.2023
(51) Int. Cl.: G01R 31/396, G01R 31/382, G01R 31/389, G01R 31/36, G01R 19/12, G01R 31/392, H01M 10/42, H01M 10/44, H01M 10/48, H02J 7/00, H02J 7/50, H02J 7/82, H02J 7/84

(54) **BATTERY DIAGNOSIS METHOD AND BATTERY SYSTEM FOR PROVIDING THE SAME**
BATTERIEDIAGNOSEVERFAHREN UND BATTERIESYSTEM ZUR BEREITSTELLUNG DAVON
PROCÉDÉ DE DIAGNOSTIC DE BATTERIE ET SYSTÈME DE BATTERIE POUR FOURNIR CELUI-CI

(30) Priority: 04.05.2022 KR 20220055702
(43) Date of publication of application: 25.12.2024
(73) Proprietor: LG Energy Solution, Ltd., Seoul 07335 (KR)
(72) Inventor: HONG, Sung Ju, Daejeon 34122 (KR); KIM, Dong Hyun, Daejeon 34122 (KR); AN, Hyo Seong, Daejeon 34122 (KR); CHOI, Geon, Daejeon 34122 (KR)
(74) Representative: Plasseraud IP
(86) International application number: PCT/KR2023/001309
(87) International publication number: WO 2023/214641

(56) References cited:
- WO-A1-2019/123907
- CN-A- 112 858 924
- JP-A- 2021 128 023
- KR-A- 20210 007 246
- KR-A- 20210 050 443
- KR-A- 20210 066 609
- US-A1- 2004 001 996

## Description

### [Technical Field]

The present invention relates to a battery diagnosis method of diagnosing the states of battery banks on the basis of the internal resistance and the states of charge (SOC), and a battery system for providing the method.

### [Background Art]

Recently, as the demand for portable electronic goods such as laptops, video cameras, and portable phones has rapidly increased, and the development of electric vehicles, energy storage batteries, robots, satellites, and so on has accelerated, research on high-performance batteries capable of repetitive charging and discharging has been actively conducted.

The currently commercialized batteries include nickel cadmium batteries, nickel hydrogen batteries, nickel zinc batteries, lithium batteries, etc., and among them, lithium batteries have freedom to be charged and discharged since they have less memory effect as compared to nickel-based batteries, and have very low self-discharge rates and high energy densities. For these advantages, they are getting the spotlight.

In general, batteries each of which includes a plurality of battery cells connected are used depending on the purpose of use. For example, a battery bank including a plurality of battery cells connected in parallel in order to increase the capacity may be used, or a battery bank including a plurality of battery cells connected in series in order to increase the output voltage may be used.

Battery banks have difficulties in terms of cost and structure in monitoring each of the battery cells connected in parallel. In general, batteries including at least one battery bank have a structural feature that they cannot be easily decomposed and separated in order to improve the stability against impact. Therefore, there are difficulties in diagnosing whether each of the battery cells included in battery banks is defective.

Further, in the case where a battery includes a plurality of battery banks, and some battery cells included in some battery banks are defective, the battery may be damaged by an inrush current which is caused by a difference in capacity between a plurality of battery banks.

An example of background art can be found in document WO 2019/123907 A1.

### [Disclosure]

### [Technical Problem]

The present invention has been made in an effort to provide a battery diagnosis method capable of accurately diagnosing the state of a battery including a plurality of battery cells, and a battery system for providing the method.

### [Technical Solution]

An aspect of the present invention provides a battery system according to claim 1. Another aspect of the present invention provides a battery diagnosis method according to claim 13.

### [Advantageous Effects]

The present invention can determine a reference value for determining defects of battery banks, on the basis of a value corresponding to the number of battery cells connected in parallel, not on the basis of a fixed value, thereby diagnosing defects of battery banks including battery cells connected in parallel, with high accuracy.

The present invention can finally estimate defective battery banks through a first defect diagnosis method of diagnosing defects on the basis of the internal resistance of battery banks and a second defect diagnosis method of diagnosing defects on the basis of the states of charge (SOC) of battery banks, whereby the accuracy of diagnosis can improve.

The present invention can improve the accuracy of diagnosis and predict the battery replacement cycle with high accuracy, thereby saving the battery replacement cost.

### [Description of the Drawings]

FIG. 1 is a drawing for explaining a battery system according to an exemplary embodiment.
FIG. 2 is a drawing illustrating an example for explaining a first resistance zone according to the exemplary embodiment.
FIG. 3 is a drawing illustrating an example for explaining a second resistance zone according to the exemplary embodiment.
FIG. 4 is a flow chart for explaining a battery diagnosis method according to an exemplary embodiment.
FIG. 5 is a flow chart for explaining the first defect diagnosis step S100 of FIG. 4 in detail.
FIG. 6 is a flow chart for explaining the second defect diagnosis step S200 of FIG. 4 in detail.

### [Mode for Invention]

Hereinafter, exemplary embodiments disclosed in this specification will be described in detail with reference to the accompanying drawings; however, the same or similar constituent components are denoted by the same or similar reference symbols, and a repeated description thereof will not be made. As used herein, the suffix 'module' and/or the suffix 'unit' for constituent elements are given and used interchangeably in consideration of only ease of preparing this specification, and the suffixes themselves do not have meanings or roles distinguishable from each other. Furthermore, the accompanying drawings are provided for helping to easily understand exemplary embodiments disclosed in the present specification.

Terms including an ordinal number, such as first and second, are used for describing various constituent elements, but the constituent elements are not limited by the terms. The terms are used only to discriminate one constituent element from another constituent element.

When a constituent element is referred to as being "connected" or "coupled" to another constituent element, it will be appreciated that it may be directly connected or coupled to the other constituent element or intervening other constituent elements may be present. In contrast, when a constituent element is referred to as being "directly connected" or "directly coupled" to another constituent element, it will be appreciated that there are no intervening other constituent elements present.

In the present application, it will be appreciated that terms "including" and "having" are intended to designate the existence of characteristics, numbers, steps, operations, constituent elements, and components described in the specification or a combination thereof, and do not exclude a possibility of the existence or addition of one or more other characteristics, numbers, steps, operations, constituent elements, and components, or a combination thereof in advance.

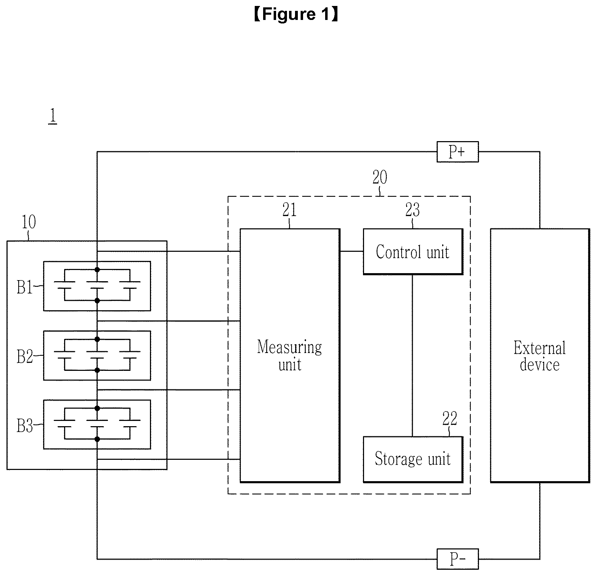

FIG. 1 is a drawing for explaining a battery system according to an exemplary embodiment.

Referring to FIG. 1, a battery system 1 includes a battery 10 and a BMS 20.

The battery 10 may include a plurality of battery banks connected in series and/or in parallel. Each battery bank may include a plurality of battery cells connected in parallel. Each battery cell refers to one independent cell which has a cathode terminal and an anode terminal and can be physically separated. For example, one pouch type lithium polymer cell may be regarded as a battery cell.

FIG. 1 shows that the battery 10 includes three battery banks B1, B2, and B3 connected in series and each of the three battery banks B1, B2, and B3 includes three battery cells connected in parallel. However, the present invention is not limited thereto, and the battery 10 may include a plurality of battery banks which is connected in parallel and each of which includes a plurality of battery cells. Hereinafter, each of the plurality of battery banks included in the battery 10 may include a plurality of battery cells having the same connection structure (series connections and parallel connections). In other words, parallel coefficients (µ) to be described may be the same.

The BMS 20 includes a measuring unit 21, a storage unit 22, and a control unit 23. FIG. 1 shows that the BMS 20 is included in the battery system 1; however, the present invention is not limited thereto, and the BMS may be mounted outside the battery system 1. Also, for example, the BMS 20 may be mounted in various systems requiring defect diagnosis on battery banks, and may function as a defect diagnosis device for the battery 10.

The measuring unit 21 may include a voltage sensor (not shown in the drawings) for measuring a bank voltage which is the voltage between both terminals of each of the plurality of battery banks, and a current sensor (not shown in the drawings) for measuring a bank current which is the current flowing through each of the plurality of battery banks. The measuring unit 21 may transmit the measurement results to the control unit 23.

With respect to each of the plurality of battery banks, the measuring unit 21 may measure a bank voltage V1 at a first time when charging of the battery 10 starts, and measure a bank voltage V2 at a second time that is a predetermined time later from the first time. The control unit 23 may calculate the voltage difference between the voltages of the battery bank measured at the first time and the second time, respectively ( ΔV = | V1 - V2| ).

With respect to each of the plurality of battery banks, the measuring unit 21 may measure the bank voltage and the bank current in a charging mode or a discharging mode. In this case, the bank current may be a charging current or a discharging current. For example, in the charging mode, with respect to each of the plurality of battery banks, the control unit 23 may determine the internal resistance on the basis of the voltage difference ( ΔV = | V2 - V1| ) and the charging current. Hereinafter, it is assumed that the battery banks is capable of charging and/or discharging at constant current.

With respect to each of the plurality of battery banks, the storage unit 22 may store an internal resistance value which the control unit 23 estimates on the basis of at least one of the bank voltage and the bank current. With respect to each of the plurality of battery banks, the storage unit may store the state of charge (SOC) which the control unit 23 estimates on the basis of at least one of the bank voltage and the bank current. By various known prior methods, the control unit 23 may estimate the internal resistance value and the state of charge (SOC) relative to each of the plurality of battery banks.

The control unit 23 may perform a first defect diagnosis of determining first diagnosis banks on the basis of the internal resistance values of the plurality of battery banks. The control unit 23 may perform a second defect diagnosis of determining second diagnosis banks on the basis of the states of charge (SOC) of the plurality of battery banks. In this case, the first diagnosis banks are battery banks determined as abnormal as the result of the first defect diagnosis. The second diagnosis banks are battery banks determined as abnormal as the result of the second defect diagnosis. According to the exemplary embodiment, a battery bank determined as normal during the first defect diagnosis may be used as a reference battery bank during the second defect diagnosis.

For example, the control unit 23 may perform the second defect diagnosis on all of the plurality of battery banks, regardless of the result of the first defect diagnosis. For another example, the control unit 23 may perform the second defect diagnosis on only battery banks determined as first diagnosis banks among the plurality of battery banks during the first defect diagnosis. In this case, the number of diagnosis objects of the second defect diagnosis decreases, so the diagnosis time can be saved.

According to the exemplary embodiment, the control unit 23 may diagnose, as defective battery banks, battery banks determined as first diagnosis banks and second diagnosis banks among plurality of battery banks. According to another exemplary embodiment, the control unit 23 may diagnose battery banks of the plurality of battery banks determined as second diagnosis banks, as defective battery banks.

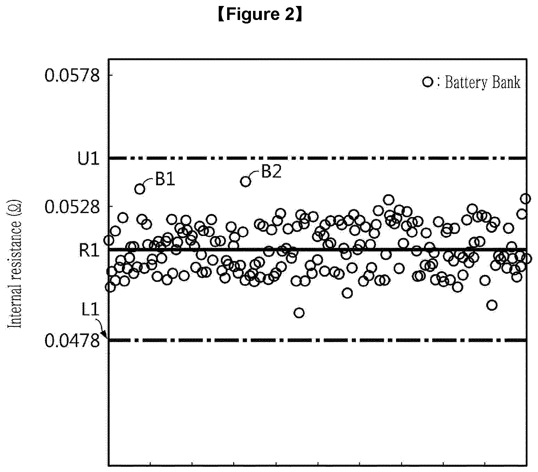

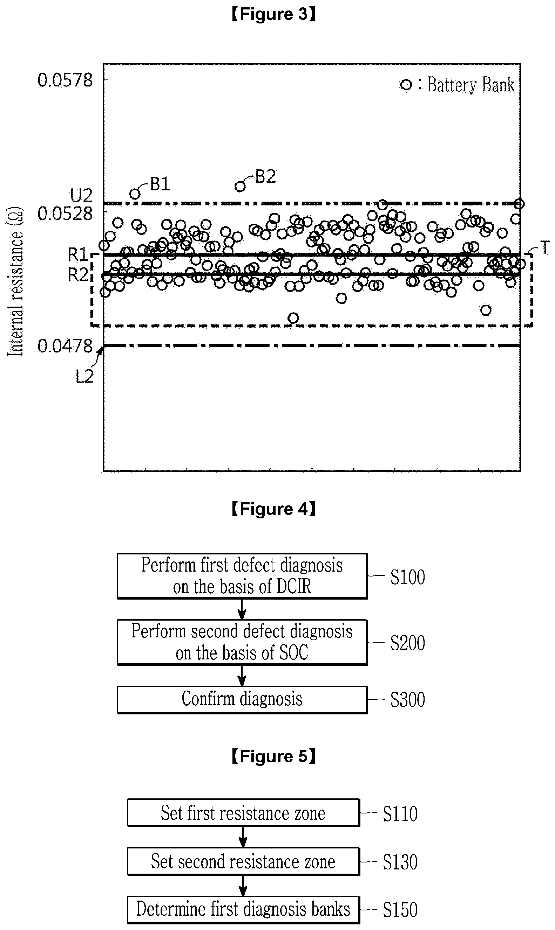

Hereinafter, a method of determining a first resistance zone and a second resistance zone for the first defect diagnosis will be described in detail with reference to FIG. 2 and FIG. 3.

FIG. 2 is a drawing illustrating an example for explaining a first resistance zone according to the exemplary embodiment.

Referring to FIG. 2, the control unit 23 may determine first reference resistance and a resistance deviation on the basis of a plurality of first internal resistance values related to the plurality of battery banks, and determine a first resistance zone on the basis of the first reference resistance and the resistance deviation.

First, the control unit 23 may calculate the internal resistance value of each of the plurality of battery banks on the basis of the following Equation 1. ${DCIR}_{i} = \frac{Δ {V}_{i}}{I}$

Here, DCIR is the internal resistance (Ω) of a battery bank, and I is the bank current (mA). ΔV is a change in the voltage (mV) of the battery bank for a predetermined time. i is an index identifying each battery bank, and may be equal to or larger than 1 and equal to or smaller than n. n may be the total number of the plurality of battery banks to undergo state diagnosis by a battery diagnosis apparatus 100.

For example, the control unit 23 may calculate the difference between a first voltage V1 and a second voltage V2 of a battery bank, i.e., the voltage difference (ΔV = |V2 - V1| ). Since the magnitude of the charging current (I) for the battery bank is constant, the control unit 23 may calculate the internal resistance (DCIR) of the battery bank on the basis of the voltage difference (ΔV) and the bank current (I). In this case, the first voltage V1 may be the bank voltage measured at the first time when charging started, and the second voltage V2 may be bank voltage measured at the second time that was a predetermined time later from the first time.

Subsequently, the control unit 23 may set the median value or average of the plurality of internal resistance values of the plurality of battery banks, as a first reference resistance R1. It may be preferable that a first reference resistance R1 be the median value of the internal resistance values of a plurality of battery banks. Specifically, the control unit 23 may set an internal resistance value which is positioned at the center when the internal resistance values of the plurality of battery banks are arranged in the order of magnitude, as a first reference resistance R1.

Next, the control unit 23 may calculate the median absolute deviation (D) of the plurality of internal resistance values of the plurality of battery banks related to the first reference resistance R1, and convert the median absolute deviation (D) into a resistance deviation, using a predetermined scale constant.

For example, the control unit 23 may calculate the median absolute deviation (D) of the plurality of internal resistance values of the plurality of battery banks related to the first reference resistance R1, using the following Equation 2. $D = median \left(\left|{DCIR}_{i}-R1\right|\right) , \left(1\leq i\leq n\right)$

Here, i is an index indicating each battery bank, and may be equal to or larger than 1 and equal to or smaller than n. n may be the total number of the plurality of battery banks to be diagnosed. R1 is a first reference resistance, and DCIRᵢ is the internal resistance of the i-th battery bank. Median() is a function that outputs the median value related to |DCIRᵢ - R1|, and D may be the median absolute deviation (hereinafter, referred to as the absolute deviation). In other words, D may be an absolute deviation between the first reference resistance R1 and the internal resistance (DCIRᵢ) values of the plurality of battery banks.

For example, the control unit 23 may calculate a scale constant, using the following Equation 3, and convert the absolute deviation into a resistance deviation, using the following Equation 4. $C = - \frac{1}{\sqrt{2} \times erfcinv \left(a\right)}$

Here, C is a scale constant, and erfcinv(a) is an inverse complementary error function, and a is a constant. For example, when a is 3/2, erfcinv(3/2) may be the output value of the inverse complementary error function related to the input value 3/2. $S = D \times C$

Here, S is a resistance deviation that is obtained by conversion, and D is an absolute deviation according to Equation 2, and C is a scale constant according to Equation 3.

Next, the control unit 23 may determine a first resistance zone on the basis of the first reference resistance R1 and the resistance deviation S.

Specifically, referring to FIG. 2, the control unit 23 may calculate a first upper threshold U1 by adding the resistance deviation S to the first reference resistance R1. In other words, the control unit 23 may calculate the first upper threshold U1 by calculating "R1 + S". Also, the control unit 23 may calculate a first lower threshold L1 by subtracting the resistance deviation from the first reference resistance R1. In other words, the control unit 23 may calculate the first lower threshold L1 by calculating "R1 - S".

Referring to FIG. 2, the Y-axis represents internal resistance (Ω), and the X-axis may represent the serial numbers of battery banks. In other words, the values on the X-axis are values independent from internal resistance values, and any factor capable of identifying each of the plurality of battery banks may be applied without limitation.

For example, a first lower threshold L1 and a first upper threshold U1 may be set symmetrically relative to the first reference resistance R1. The resistance zone from the first lower threshold L1 to the first upper threshold U1 may be set as the first resistance zone. Further, in the exemplary embodiment of FIG. 2, all of the internal resistance values of the plurality of battery banks may be included in the first resistance zone.

FIG. 3 is a drawing illustrating an example for explaining a second resistance zone according to the exemplary embodiment.

Referring to FIG. 3, the control unit 23 may determine, as target banks, a plurality of battery banks having internal resistance values smaller than the first reference resistance R1 among the plurality of battery banks. The control unit 23 may determine a second reference resistance R2 on the basis of a plurality of second internal resistance values related to the plurality of target banks. The control unit 23 may determine a second resistance zone on the basis of the second reference resistance R2 and a parallel deviation. In this case, a parallel deviation P may be a value corresponding to the connection structure of a plurality of battery cells included in a target bank.

First, the control unit 23 may determine, as target banks, a plurality of battery banks having internal resistance values smaller than the first reference resistance R1 among the plurality of battery banks.

As the first reference resistance R1, the median value or average of the plurality of battery banks may be applied. In the case where the first reference resistance R1 is the average of the internal resistance values of the plurality of battery banks, battery banks having internal resistance values equal to or smaller than the average may be selected as target banks. On the contrary, in the case where the first reference resistance R1 is the median value of the internal resistance values of the plurality of battery banks, battery banks having internal resistance values included in the bottom 50% may be selected as target banks.

Subsequently, the control unit 23 may determine a second reference resistance R2 on the basis of a plurality of second internal resistance values related to the plurality of target banks.

The second reference resistance R2 is a value representing the internal resistance values of the plurality of target banks, and may be the median value, the average, or the like. It may be preferable that the second reference resistance R2 be the average of the plurality of internal resistance values of the plurality of target banks.

Next, the control unit 23 may calculate a parallel coefficient µ from the number of parallel connections, and calculate a parallel deviation P by multiplying the parallel coefficient µ and the second reference resistance R2 together.

For example, the control unit 23 may calculate a parallel coefficient using the following Equation 5. Here, µ is a parallel coefficient, and m is the number of parallel connections. b is a constant, and may be, for example, 0 or 1. In other words, the parallel coefficient µ may be related to the reciprocal of the number of parallel connections (m). $μ = \frac{1}{m - b}$

For example, the control unit 23 may calculate a parallel deviation P using the following Equation 6. Here, P is a parallel deviation, and R2 is a second reference resistance, and µ is a parallel coefficient according to Equation 5. $P = R 2 \times μ$

Next, the control unit 23 may determine a second resistance zone on the basis of the second reference resistance R2 and the parallel deviation P.

Specifically, the control unit 23 may calculate a second upper threshold U2 by adding the parallel deviation P to the second reference resistance R2. In other words, the control unit 23 may calculate a second upper threshold U2 by calculating "R2 + P". The control unit 23 may calculate a second lower threshold L2 by subtracting the parallel deviation P from the second reference resistance R2. In other words, the control unit 23 may calculate a second lower threshold L2 by calculating "R2 - P".

Referring to FIG. 3, the Y-axis represents internal resistance (Ω), and the X-axis may represent the serial numbers of battery banks. In other words, the values on the X-axis are values independent from internal resistance, and any factor capable of identifying each of the plurality of battery banks may be applied without limitation. Specifically, in the exemplary embodiments of FIG. 2 and FIG. 3, the plurality of battery banks may be identical.

For example, a second lower threshold L2 and a second upper threshold U2 may be set symmetrically relative to the second reference resistance R2. The resistance zone from the second lower threshold L2 to the second upper threshold U2 may be set as a second resistance zone.

The control unit 23 may determine first diagnosis banks in the light of both of the first resistance zone and the second resistance zone, not in the light of only one of the first resistance zone and the second resistance zone.

Preferably, the control unit 23 may determine that battery banks having internal resistance values belonging to both of the first resistance zone and the second resistance zone among the plurality of battery banks are normal. The control unit 23 may determine that battery banks having internal resistance which is out of the first resistance zone or the second resistance zone among the plurality of battery banks are abnormal, and determine them as first diagnosis banks. According to an exemplary embodiment, the battery banks determined as normal during the first defect diagnosis may be used as reference battery banks for the second defect diagnosis.

For example, referring to FIG. 2, the internal resistance values of a first battery bank B1 and a second battery bank B2 of the plurality of battery banks may be included in the first resistance zone. However, referring to FIG. 3, the internal resistance values of the first battery bank B1 and the second battery bank B2 may not be included in the second resistance zone. In this case, the control unit 23 may determine the first battery bank B1 and the second battery bank B2 as first diagnosis banks, and then further diagnose whether there is any defect, on the basis of the state of charge (SOC).

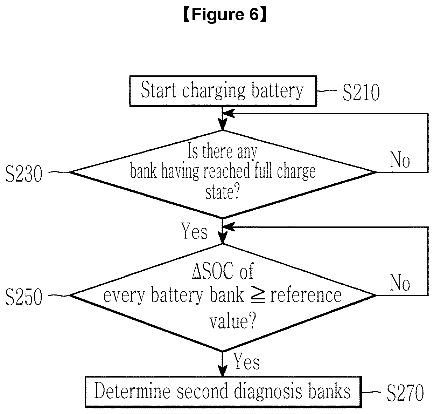

FIG. 4 is a flow chart for explaining a battery diagnosis method according to an exemplary embodiment, and FIG. 5 is a flow chart for explaining the first defect diagnosis step S100 of FIG. 4 in detail, and FIG. 6 is a flow chart for explaining the second defect diagnosis step S200 of FIG. 4 in detail.

Hereinafter, on the basis of FIG. 1 to FIG. 6, a method of diagnosing defects of a plurality of battery banks and a battery system for providing the method will be described.

Referring to FIG. 4, first, the control unit 23 performs a first defect diagnosis on the plurality of battery banks on the basis of the internal resistance (DCIR) (S100).

In step S100, referring to FIG. 5, the control unit 23 determines a first reference resistance and a resistance deviation on the basis of a plurality of first internal resistance values related to the plurality of battery banks, and determines a first resistance zone on the basis of the first reference resistance and the resistance deviation (S110).

For example, the control unit 23 may set the median value of the plurality of internal resistance values of the plurality of battery banks, as a first reference resistance R1. The control unit 23 may calculate the median absolute deviation (D) between the first reference resistance R1 and the internal resistance values of the plurality of battery banks, using the above Equation 2. The control unit 23 may determine a scale constant using the above Equation 3, and convert the median absolute deviation (D) into a resistance deviation S using the above Equation 4.

The control unit 23 may calculate a first upper threshold U1 by adding the resistance deviation S to the first reference resistance R1. The control unit 23 may calculate a first lower threshold L1 by subtracting the resistance deviation S from the first reference resistance R1. Referring to FIG. 2, the control unit 23 may determine the resistance zone from the first lower threshold L1 to the first upper threshold U1, as a first resistance zone.

In step S100, the control unit 23 determines, as target banks, a plurality of battery banks having internal resistance values smaller than the first reference resistance R1 among the plurality of battery banks, and determines a second reference resistance R2 on the basis of a plurality of second internal resistance values related to the plurality of target banks, and determines a second resistance zone on the basis of the second reference resistance R2 and a parallel deviation (S130).

For example, in the case where the first reference resistance R1 is the median value of the internal resistance values of the plurality of battery banks, the control unit 23 may select, as target banks, battery banks having internal resistance values included in the bottom 50%.

The control unit 23 may determine the average of the internal resistance values of the plurality of target banks, as a second reference resistance R2. Also, the control unit 23 may calculate a parallel coefficient µ from the number of parallel connections (m), and calculate a parallel deviation P by multiplying the parallel coefficient µ and the second reference resistance R2 together. For example, the control unit 23 may calculate a parallel coefficient µ using the above Equation 5, and calculate a parallel deviation P using the above Equation 6. In this case, the parallel deviation P may be a value corresponding to the connection structure of a plurality of battery cells included in a target bank.

The control unit 23 may calculate a second upper threshold U2 by adding the parallel deviation P to the second reference resistance R2. The control unit 23 may calculate a second lower threshold L2 by subtracting the parallel deviation P from the second reference resistance R2. Referring to FIG. 3, the control unit 23 may determine the resistance zone from the second lower threshold L2 to the second upper threshold U2, as a second resistance zone.

In step S100, the control unit 23 determines, as first diagnosis banks, battery banks having internal resistance values which are out of the first resistance zone or the second resistance zone among the plurality of battery banks (S150).

For example, referring to FIG. 2, the internal resistance values of a first battery bank B1 and a second battery bank B2 of the plurality of battery banks may be included in the first resistance zone. However, referring to FIG. 3, the internal resistance of the first battery bank B1 and the second battery bank B2 may not be included in the second resistance zone. In this case, the control unit 23 may determine the first battery bank B1 and the second battery bank B2 as first diagnosis banks.

Subsequently, the control unit 23 performs a second defect diagnosis on the battery banks on the basis of the states of charge (SOC) of the plurality of battery banks (S200).

According to an exemplary embodiment, the control unit 23 may perform a second defect diagnosis on the first diagnosis banks. According to another exemplary embodiment, the control unit 23 may perform a second defect diagnosis on the plurality of battery banks.

Referring to FIG. 6, in step S200, when a predetermined condition is satisfied, the control unit 23 proceeds to a charging mode of charging the battery 10 with the electricity of an external device (S210).

For example, in the case where a state-of-charge (SOC) range equal to or larger than 20% and smaller than 80% is set as a battery use range, when the state of charge (SOC) of the battery 10 reaches 20%, the control unit 23 may perform the charging mode.

In step S200, the control unit 23 determines whether a first diagnosis condition that there should be at least one battery bank having reached a state of charge (SOC) indicating a full charge state among the plurality of battery banks included in the battery 10 is satisfied (S230).

When a predetermined diagnosis condition is satisfied in the charging mode of charging the battery with the electricity of the external device, the control unit 23 may perform a second defect diagnosis in which it determines the ratios of second state-of-charge change amounts (ΔSOC2) of battery banks to a first state-of-charge change amount (ΔSOC1) of a reference battery bank (ΔSOC2/ΔSOC1), and determines second diagnosis banks by comparing the determined ratios with a diagnosis reference value.

For example, in the case where a state-of-charge (SOC) range equal to or larger than 20% and smaller than 80% is set as a battery use range, when the plurality of battery banks included in the battery 10 includes at least one battery bank in which the state of charge (SOC) has reached 80%, the control unit 23 may determine that some battery banks having reached a full charge state exist. In other words, the full charge state may be determined by the predetermined battery use range.

In step S200, when it is determined that the first diagnosis condition is satisfied (Yes in step S230), the control unit 23 determines whether a second diagnosis condition that the state-of-charge change amounts of the plurality of battery banks should be equal to or larger than a condition reference value is satisfied (S250).

For example, it is assumed that the condition reference value is 45%. In the case where the state-of-charge change amounts of the plurality of battery banks from the charging start time, i.e., their state-of-charge increases are equal to or larger than 45%, the control unit 23 may determine that the second diagnosis condition is satisfied.

For another example, it is assumed that in the middle of the charging mode, at a point of time, a first battery bank B1 has been fully charged from the state of charge of 20% to 80% (ΔSOC₁ = 60%), and a second battery bank B2 has been charged from the state of charge of 25% to 70% (ΔSOC₂ = 45%), and a third battery bank B3 has been charged from the state of charge of 25% to 72% (ΔSOC₃ = 47%), and a fourth battery bank B4 has been charged from the state of charge of 25% to 70% (ΔSOC₄ = 45%), and a fifth battery bank B5 has been charged from the state of charge of 20% to 70% (ΔSOC₅ = 50%). The control unit 23 may determine that the first diagnosis condition is satisfied, because the first battery bank B1 has reached the full charge state (SOC = 80%), and determine that the second diagnosis condition is satisfied, because the state-of-charge change amounts of the first to fifth battery banks B1, B2, B3, B4, and B5 (ΔSOC₁₋₅ = 60%, 45%, 47%, 45%, 50%) are equal to or larger than the condition reference value (45%). In other words, the control unit 23 may determine that the first diagnosis condition and the second diagnosis condition are satisfied.

In step S200, when it is determined that the second diagnosis condition is satisfied (Yes in S250), the control unit 23 determines the ratios of the second state-of-charge change amounts of battery banks to the first state-of-charge change amount of the reference battery bank, and determines second diagnosis banks by comparing the ratios with the diagnosis reference value (S270).

As the reference battery bank, a battery bank diagnosed as normal or a new battery bank which has never been used may be determined. According to an exemplary embodiment, the reference battery bank may be a battery bank determined as normal in the first defect diagnosis step. For example, in the case where a plurality of battery banks has been determined as normal in the first defect diagnosis step, the control unit 23 may determine, as a reference battery bank, a battery bank having the smallest state-of-charge change amount (ΔSOC) calculated in the second defect diagnosis step. However, the present invention is not limited thereto, and the control unit 23 may determine, as a reference battery bank, one of the plurality of battery banks determined as being normal during the first defect diagnosis.

For example, it is assumed that the battery 10 includes first to fifth battery banks B1 to B5, and in the first defect diagnosis step, the first and second battery banks B1 and B2 are diagnosed as first diagnosis banks corresponding to the abnormal state, and the third to fifth battery banks B3, B4, and B5 are diagnosed as normal. In the second defect diagnosis step, when it is assumed that the state-of-charge change amounts (ΔSOC₁₋₃) of the third to fifth battery banks B3, B4, and B5 are 47%, 45%, and 50%, respectively, the control unit 23 may determine the fourth battery bank B4 having the smallest state-of-charge change amount, as a reference battery bank.

The diagnosis reference value is determined on the basis of the number of battery cells connected in parallel in a battery bank. The diagnosis reference value is determined by the following Equation 7. ${Th}_{1} = \frac{m}{m - n}$

Here, Th1 is a diagnosis reference value, and m is the number of battery cells connected in parallel in a battery bank, and n is a natural number smaller than m.

For example, when it is desired to diagnose a case where at least one battery cell is defective, n may be set to 1. For another example, when it is desired to diagnose a case where two or more battery cells are defective as a case where there are some defective battery cells, n may be set to 2. In other words, when it is desired to detect battery banks each of which includes at least one defect battery cell, n in the above Equation 7 may be set to 1. Hereinafter, it is assumed that m is 5 and n is 1. In this case, the diagnosis reference value Th1 may be set to 1.25.

For example, it is assumed that the state of charge of a reference battery bank has changed from 25% to 70%, and the state of charge of a first battery bank B1 has changed from 20% to 80%. Since the ratio of a second state-of-charge change amount which is the state-of-charge change amount of the first battery bank (60% = 80% - 20%) to a first state-of-charge change amount which is the state-of-charge change amount of the reference battery bank (45% = 70% - 25%) (1.33 = 60%/45%) is equal to or larger than the diagnosis reference value (Th1 = 1.25), the control unit 23 may determine the first battery bank B1 as a second diagnosis bank.

Subsequently, the control unit 23 diagnoses, as defective battery banks, battery banks determined as first diagnosis banks and second diagnosis banks among the plurality of battery banks (S300).

According to an exemplary embodiment, the accuracy of diagnosis can be improved by finally diagnosing defective battery banks by a first defect diagnosis method of diagnosing defects on the basis of the internal resistance of battery banks and a second defect diagnosis method of diagnosing defects on the basis of the states of charge (SOC) of battery banks.

According to another exemplary embodiment, the control unit 23 may diagnose defective battery banks by only the second defect diagnosis method of diagnosing defects on the basis of the states of charge (SOC) of battery banks. In this case, the control unit 23 may determine a reference battery bank by the first defect diagnosis method described above, and determine second diagnosis banks on the basis of the state-of-charge change amount ratios between the reference battery bank and battery banks. The second diagnosis banks may be defective battery banks.

## Claims

1. A battery system (1) comprising:
a battery (10) that includes a plurality of battery banks (B1, B2, B3) each of which includes a plurality of battery cells; and
a control unit (23) that determines the ratios of second state-of-charge change amounts of battery banks (B1, B2, B3) to a first state-of-charge change amount of a reference battery bank, and diagnoses defects of battery banks (B1, B2, B3) by comparing the ratios with a diagnosis reference value, when a predetermined diagnosis condition is satisfied in a charging mode of charging the battery (10) with the electricity of an external device,
wherein the diagnosis reference value is determined on the basis of the number of battery cells connected in parallel in a battery bank;
wherein
the diagnosis reference value is determined by the following equation: ${Th}_{1} = \frac{m}{m - n}$
wherein Th1 is a diagnosis reference value, and m is the number of battery cells connected in parallel in a battery bank, and n is a natural number smaller than m, wherein n is 1 or 2.

2. The battery system of claim 1, wherein
in the charging mode, when a first diagnosis condition that at least one battery bank should reach a full charge state and a second diagnosis condition that the state-of-charge change amount of each of the plurality of battery banks (B1, B2, B3) should be equal to or larger than a condition reference value are satisfied, the control unit (23) diagnoses a defect of the plurality of battery banks (B1, B2, B3).

3. The battery system of claim 1, wherein
the control unit (23) performs the following:
determining a first reference resistance (R1) and a resistance deviation (S) on the basis of a plurality of first internal resistance values related to the plurality of battery banks (B1, B2, B3), and determining a first resistance zone on the basis of the first reference resistance (R1) and the resistance deviation (S);
determining, as target banks, a plurality of battery banks having internal resistance values smaller than the first reference resistance (R1) among the plurality of battery banks (B1, B2, B3), and determining a second reference resistance (R2) on the basis of a plurality of second internal resistance values related to the plurality of target banks (B1, B2, B3), and determining a second resistance zone on the basis of the second reference resistance and a parallel deviation corresponding to the connection structure of the plurality of battery cells included in each target bank; and
determining, as the reference battery bank, a battery bank having an internal resistance value belonging to the first resistance zone and the second resistance zone among the plurality of battery banks (B1, B2, B3).

4. The battery system of claim 1, wherein the control unit (23) is configured to::
determine first diagnosis banks on the basis of the internal resistance of the plurality of battery banks (B1, B2, B3);
determine second diagnosis banks by comparing the ratios of second state-of-charge change amounts of battery banks to a first state-of-charge change amount of a reference battery bank with the diagnosis reference value, when a predetermined diagnosis condition is satisfied in a charging mode of charging the battery with the electricity of an external device, and
diagnose, as defective battery banks, battery banks determined as the first diagnosis banks and the second diagnosis banks among the plurality of battery banks (B1, B2, B3).

5. The battery system of claim 4, wherein
in the charging mode, when a first diagnosis condition that at least one battery bank should reach a full charge state and a second diagnosis condition that the state-of-charge change amount of each of the plurality of battery banks (B1, B2, B3) should be equal to or larger than a condition reference value are satisfied, the control unit (23) determines the second diagnosis banks.

6. The battery system of claim 4, wherein
the control unit (23) performs the following:
determining a first reference resistance (R1) and a resistance deviation on the basis of a plurality of first internal resistance values related to the plurality of battery banks (B1, B2, B3), and determining a first resistance zone on the basis of the first reference resistance (R1) and the resistance deviation;
determining, as target banks, a plurality of battery banks having internal resistance values smaller than the first reference resistance (R1) among the plurality of battery banks (B1, B2, B3), and determining a second reference resistance (R2) on the basis of a plurality of second internal resistance values related to the plurality of target banks, and determining a second resistance zone on the basis of the second reference resistance (R2) and a parallel deviation corresponding to the connection structure of the plurality of battery cells included in each target bank; and
determining, as the first diagnosis bank, a battery bank having an internal resistance value which is out of the first resistance zone or the second resistance zone among the plurality of battery banks (B1, B2, B3).

7. The battery system of claim 5, wherein
the control unit (23) determines, as the reference battery bank, a battery bank having an internal resistance value belonging to the first resistance zone and the second resistance zone among the plurality of battery banks (B1, B2, B3).

8. The battery system of claim 6, wherein
the control unit (23) performs the following:
determining the median value of the plurality of first internal resistance values as the first reference resistance (R1); and
determining an absolute deviation between the first reference resistance (R1) and the internal resistance of the plurality of individual battery banks, and converting the absolute deviation into the resistance deviation, using a predetermined scale constant.

9. The battery system of claim 8, wherein
the control unit (23) determines a first upper threshold (U1) by adding the resistance deviation to the first reference resistance (R1), and determines a first lower threshold (L1) by subtracting the resistance deviation from the first reference resistance (R1), and determines the first resistance zone on the basis of the first upper threshold (U1) and the first lower threshold (L1).

10. The battery system of claim 6, wherein
the control unit (23) performs the following:
determining the average of the plurality of second internal resistance values as the second reference resistance (R2); and
determining a parallel coefficient on the basis of the number of battery cells connected in parallel included in each target bank, and determining the parallel deviation by multiplying the parallel coefficient and the second reference resistance(R2) together.

11. The battery system of claim 10, wherein
the control unit (23) performs the following:
determining a second upper threshold (U2) by adding the parallel deviation to the second reference resistance (R2);
determining a second lower threshold (L2) by subtracting the parallel deviation from the second reference resistance (R2); and
determining the second resistance zone on the basis of the second upper threshold (U2) and the second lower threshold (L2).

12. The battery system of claim 4, further comprising:
a measuring unit (21) that measures a bank voltage which is the voltage between both terminals of each of the plurality of battery banks (B1, B2, B3) and a bank current which is the current flowing through each of the plurality of battery banks (B1, B2, B3); and
a storage unit (22) that stores an internal resistance value and a state of charge (SOC) which is estimated on the basis of at least one of the bank voltage and the bank current.

13. A method of diagnosing defects of a battery including a plurality of battery banks each of which includes a plurality of battery cells, comprising:
a first defect diagnosis step (S100) of determining first diagnosis banks on the basis of the internal resistance of the plurality of battery banks (B1, B2, B3);
a second defect diagnosis step (S200) of determining second diagnosis banks by comparing the ratios of second state-of-charge change amounts of battery banks to a first state-of-charge change amount of a reference battery bank with a diagnosis reference value, when a predetermined diagnosis condition is satisfied in a charging mode of charging the battery with the electricity of an external device; and
a diagnosis confirming step of diagnosing, as defective battery banks, battery banks determined as the first diagnosis banks and the second diagnosis banks among the plurality of battery banks (B1, B2, B3),
wherein the diagnosis reference value is determined on the basis of the number of battery cells connected in parallel in a battery bank;
wherein
the diagnosis reference value is determined by the following equation: ${Th}_{1} = \frac{m}{m - n}$
wherein Th₁ is a diagnosis reference value, and m is the number of battery cells connected in parallel in a battery bank, and n is a natural number smaller than m, wherein n is 1 or 2.

14. The battery diagnosis method of claim 13, wherein
in the charging mode, when a first diagnosis condition that at least one battery bank should reach a full charge state and a second diagnosis condition that the state-of-charge change amount of each of the plurality of battery banks (B1, B2, B3) should be equal to or larger than a condition reference value are satisfied, the second defect diagnosis step (S200) determines the second diagnosis banks.

15. The battery diagnosis method of claim 13, wherein
the first defect diagnosis step (S100) includes:
a step of determining (S110) a first reference resistance (R1) and a resistance deviation on the basis of a plurality of first internal resistance values related to the plurality of battery banks (B1, B2, B3), and determining a first resistance zone on the basis of the first reference resistance (R1) and the resistance deviation;
a step of determining (S130), as target banks, a plurality of battery banks having internal resistance values smaller than the first reference resistance (R1) among the plurality of battery banks (B1, B2, B3), and determining a second reference resistance (R2) on the basis of a plurality of second internal resistance values related to the plurality of target banks, and determining a second resistance zone on the basis of the second reference resistance (R2) and a parallel deviation corresponding to the connection structure of the plurality of battery cells included in each target bank; and
a step of determining the first diagnosis banks and the reference battery bank by comparing the internal resistance value of each of the plurality of battery banks (B1, B2, B3) with the first resistance zone and the second resistance zone.

16. The battery diagnosis method of claim 15, wherein
the step of determining the first resistance zone performs the following:
determining the median value of the plurality of first internal resistance values as the first reference resistance (R1); and
determining an absolute deviation between the first reference resistance (R1) and the internal resistance of the plurality of individual battery banks, and converting the absolute deviation into the resistance deviation, using a predetermined scale constant.

17. The battery diagnosis method of claim 16, wherein
the step of determining the first resistance zone determines a first upper threshold (U1) by adding the resistance deviation to the first reference resistance (R1), and determines a first lower threshold (L1) by subtracting the resistance deviation from the first reference resistance (R1), and determines the first resistance zone on the basis of the first upper threshold (U1) and the first lower threshold (L1).

18. The battery diagnosis method of claim 15, wherein
the step of determining the second resistance zone performs the following:
determining the average of the plurality of second internal resistance values as the second reference resistance (R2); and
determining a parallel coefficient on the basis of the number of battery cells connected in parallel included in each target bank, and determining the parallel deviation by multiplying the parallel coefficient and the second reference resistance (R2) together.

19. The battery diagnosis method of claim 18, wherein
the step of determining the second resistance zone performs the following:
determining a second upper threshold (U2) by adding the parallel deviation to the second reference resistance (R2);
determining a second lower threshold (L2) by subtracting the parallel deviation from the second reference resistance (R2); and
determining the second resistance zone on the basis of the second upper threshold (U2) and the second lower threshold (L2).

## Patentansprüche

1. Batteriesystem (1), umfassend:
eine Batterie (10), die eine Vielzahl von Batteriebänken (B1, B2, B3) enthält, von denen jede eine Vielzahl von Batteriezellen enthält; und
eine Steuereinheit (23), die die Verhältnisse von zweiten Ladezustandsänderungsbeträgen von Batteriebänken (B1, B2, B3) zu einem ersten Ladezustandsänderungsbetrag einer Referenzbatteriebank bestimmt und Defekte der Batteriebänke (B1, B2, B3) durch Vergleichen der Verhältnisse mit einem Diagnose-Referenzwert diagnostiziert, wenn eine vorbestimmte Diagnosebedingung in einem Lademodus des Ladens der Batterie (10) mit dem Strom einer externen Vorrichtung erfüllt ist,
wobei der Diagnose-Referenzwert auf der Grundlage der Anzahl von parallel geschalteten Batteriezellen in einer Batteriebank bestimmt wird;
wobei
der Diagnose-Referenzwert durch die folgende Gleichung bestimmt wird: ${Th}_{1} = \frac{m}{m - n}$
wobei Th1 ein Diagnose-Referenzwert ist, und m die Anzahl von parallel geschalteten Batteriezellen in einer Batteriebank ist, und n eine natürliche Zahl kleiner als m ist,
wobei n 1 oder 2 ist.

2. Batteriesystem nach Anspruch 1, wobei
im Lademodus, wenn eine erste Diagnosebedingung, dass mindestens eine Batteriebank einen vollen Ladezustand erreichen sollte, und eine zweite Diagnosebedingung, dass der Ladezustandsänderungsbetrag jeder der Vielzahl von Batteriebänken (B1, B2, B3) gleich oder größer als ein Bedingungsreferenzwert sein sollte, erfüllt sind, die Steuereinheit (23) einen Defekt der Vielzahl von Batteriebänken (B1, B2, B3) diagnostiziert.

3. Batteriesystem nach Anspruch 1, wobei
die Steuereinheit (23) Folgendes durchführt:
Bestimmen eines ersten Referenzwiderstands (R1) und einer Widerstandsabweichung (S) auf der Grundlage einer Vielzahl von ersten Innenwiderstandswerten in Bezug auf die Vielzahl von Batteriebänken (B1, B2, B3), und Bestimmen einer ersten Widerstandszone auf der Grundlage des ersten Referenzwiderstands (R1) und der Widerstandsabweichung (S);
Bestimmen, als Zielbänke, einer Vielzahl von Batteriebänken mit Innenwiderstandswerten, die kleiner als der erste Referenzwiderstand (R1) sind, aus der Vielzahl von Batteriebänken (B1, B2, B3), und Bestimmen eines zweiten Referenzwiderstands (R2) auf der Grundlage einer Vielzahl von zweiten Innenwiderstandswerten in Bezug auf die Vielzahl von Zielbänken (B1, B2, B3), und Bestimmen einer zweiten Widerstandszone auf der Grundlage des zweiten Referenzwiderstands und einer Parallelabweichung, die der Verbindungsstruktur der Vielzahl von Batteriezellen entspricht, die in jeder Zielbank enthalten sind; und
Bestimmen, als Referenzbatteriebank, einer Batteriebank mit einem Innenwiderstandswert, der zur ersten Widerstandszone und zur zweiten Widerstandszone gehört, aus der Vielzahl von Batteriebänken (B1, B2, B3).

4. Batteriesystem nach Anspruch 1, wobei die Steuereinheit (23) konfiguriert ist, um:
erste Diagnosebänke auf der Grundlage des Innenwiderstands der Vielzahl von Batteriebänken (B1, B2, B3) zu bestimmen;
zweite Diagnosebänke durch Vergleichen der Verhältnisse von zweiten Ladezustandsänderungsbeträgen von Batteriebänken zu einem ersten Ladezustandsänderungsbetrag einer Referenzbatteriebank mit dem Diagnose-Referenzwert zu bestimmen, wenn eine vorbestimmte Diagnosebedingung in einem Lademodus des Ladens der Batterie mit dem Strom einer externen Vorrichtung erfüllt ist, und
als defekte Batteriebänke, Batteriebänke zu diagnostizieren, die als die ersten Diagnosebänke und die zweiten Diagnosebänke unter der Vielzahl von Batteriebänken (B1, B2, B3) bestimmt wurden.

5. Batteriesystem nach Anspruch 4, wobei
im Lademodus, wenn eine erste Diagnosebedingung, dass mindestens eine Batteriebank einen vollen Ladezustand erreichen sollte, und eine zweite Diagnosebedingung, dass der Ladezustandsänderungsbetrag jeder der Vielzahl von Batteriebänken (B1, B2, B3) gleich oder größer als ein Bedingungsreferenzwert sein sollte, erfüllt sind, die Steuereinheit (23) die zweiten Diagnosebänke bestimmt.

6. Batteriesystem nach Anspruch 4, wobei
die Steuereinheit (23) Folgendes durchführt:
Bestimmen eines ersten Referenzwiderstands (R1) und einer Widerstandsabweichung auf der Grundlage einer Vielzahl von ersten Innenwiderstandswerten in Bezug auf die Vielzahl von Batteriebänken (B1, B2, B3), und Bestimmen einer ersten Widerstandszone auf der Grundlage des ersten Referenzwiderstands (R1) und der Widerstandsabweichung;
Bestimmen, als Zielbänke, einer Vielzahl von Batteriebänken mit Innenwiderstandswerten, die kleiner als der erste Referenzwiderstand (R1) sind, aus der Vielzahl von Batteriebänken (B1, B2, B3), und Bestimmen eines zweiten Referenzwiderstands (R2) auf der Grundlage einer Vielzahl von zweiten Innenwiderstandswerten in Bezug auf die Vielzahl von Zielbänken, und Bestimmen einer zweiten Widerstandszone auf der Grundlage des zweiten Referenzwiderstands (R2) und einer Parallelabweichung, die der Verbindungsstruktur der Vielzahl von Batteriezellen entspricht, die in jeder Zielbank enthalten sind; und
Bestimmen, als die erste Diagnosebank, einer Batteriebank mit einem Innenwiderstandswert, der außerhalb der ersten Widerstandszone oder der zweiten Widerstandszone liegt, aus der Vielzahl von Batteriebänken (B1, B2, B3).

7. Batteriesystem nach Anspruch 5, wobei
die Steuereinheit (23) als Referenzbatteriebank eine Batteriebank bestimmt, die einen Innenwiderstandswert hat, der zur ersten Widerstandszone und zur zweiten Widerstandszone gehört, aus der Vielzahl von Batteriebänken (B1, B2, B3).

8. Batteriesystem nach Anspruch 6, wobei
die Steuereinheit (23) Folgendes durchführt:
Bestimmen des Medianwerts der Vielzahl von ersten Innenwiderstandswerten als den ersten Referenzwiderstand (R1); und
Bestimmen einer absoluten Abweichung zwischen dem ersten Referenzwiderstand (R1) und dem Innenwiderstand der Vielzahl von einzelnen Batteriebänken, und Umwandeln der absoluten Abweichung in die Widerstandsabweichung unter Verwendung einer vorbestimmten Skalenkonstante.

9. Batteriesystem nach Anspruch 8, wobei
die Steuereinheit (23) eine erste obere Schwelle (U1) durch Addieren der Widerstandsabweichung zum ersten Referenzwiderstand (R1) bestimmt, und eine erste untere Schwelle (L1) durch Subtrahieren der Widerstandsabweichung vom ersten Referenzwiderstand (R1) bestimmt, und die erste Widerstandszone auf der Grundlage der ersten oberen Schwelle (U1) und der ersten unteren Schwelle (L1) bestimmt.

10. Batteriesystem nach Anspruch 6, wobei
die Steuereinheit (23) Folgendes durchführt:
Bestimmen des Durchschnitts der Vielzahl von zweiten Innenwiderstandswerten als den zweiten Referenzwiderstand (R2); und
Bestimmen eines Parallelkoeffizienten auf der Grundlage der Anzahl von parallel geschalteten Batteriezellen, die in jeder Zielbank enthalten sind, und Bestimmen der Parallelabweichung durch Multiplizieren des Parallelkoeffizienten und des zweiten Referenzwiderstands (R2) miteinander.

11. Batteriesystem nach Anspruch 10, wobei
die Steuereinheit (23) Folgendes durchführt:
Bestimmen einer zweiten oberen Schwelle (U2) durch Addieren der Parallelabweichung zum zweiten Referenzwiderstand (R2);
Bestimmen einer zweiten unteren Schwelle (L2) durch Subtrahieren der Parallelabweichung vom zweiten Referenzwiderstand (R2); und
Bestimmen der zweiten Widerstandszone auf der Grundlage der zweiten oberen Schwelle (U2) und der zweiten unteren Schwelle (L2).

12. Batteriesystem nach Anspruch 4, weiter umfassend:
eine Messeinheit (21), die eine Bankspannung misst, welche die Spannung zwischen beiden Anschlüssen jeder der Vielzahl von Batteriebänken (B1, B2, B3) ist, und einen Bankstrom, welcher der Strom ist, der durch jede der Vielzahl von Batteriebänken (B1, B2, B3) fließt; und
eine Speichereinheit (22), die einen Innenwiderstandswert und einen Ladezustand (SOC) speichert, der auf der Grundlage von mindestens einem von der Bankspannung und dem Bankstrom geschätzt wird.

13. Verfahren zur Diagnose von Defekten einer Batterie, die eine Vielzahl von Batteriebänken enthält, von denen jede eine Vielzahl von Batteriezellen enthält, umfassend:
einen ersten Fehlerdiagnoseschritt (S100) zum Bestimmen erster Diagnosebänke auf der Grundlage des Innenwiderstands der Vielzahl von Batteriebänken (B1, B2, B3);
einen zweiten Fehlerdiagnoseschritt (S200) zum Bestimmen zweiter Diagnosebänke durch Vergleichen der Verhältnisse von zweiten Ladezustandsänderungsbeträgen von Batteriebänken zu einem ersten Ladezustandsänderungsbetrag einer Referenzbatteriebank mit einem Diagnose-Referenzwert, wenn eine vorbestimmte Diagnosebedingung in einem Lademodus des Ladens der Batterie mit dem Strom einer externen Vorrichtung erfüllt ist; und
einen Diagnosebestätigungsschritt zum Diagnostizieren, als defekte Batteriebänke, von Batteriebänken, die als die ersten Diagnosebänke und die zweiten Diagnosebänke unter der Vielzahl von Batteriebänken (B1, B2, B3) bestimmt wurden,
wobei der Diagnose-Referenzwert auf der Grundlage der Anzahl von parallel geschalteten Batteriezellen in einer Batteriebank bestimmt wird;
wobei
der Diagnose-Referenzwert durch die folgende Gleichung bestimmt wird: ${Th}_{1} = \frac{m}{m - n}$
wobei Th₁ ein Diagnose-Referenzwert ist, und m die Anzahl von parallel geschalteten Batteriezellen in einer Batteriebank ist, und n eine natürliche Zahl kleiner als m ist, wobei n 1 oder 2 ist.

14. Batteriediagnoseverfahren nach Anspruch 13, wobei
im Lademodus, wenn eine erste Diagnosebedingung, dass mindestens eine Batteriebank einen vollen Ladezustand erreichen sollte, und eine zweite Diagnosebedingung, dass der Ladezustandsänderungsbetrag jeder der Vielzahl von Batteriebänken (B1, B2, B3) gleich oder größer als ein Bedingungsreferenzwert sein sollte, erfüllt sind, der zweite Fehlerdiagnoseschritt (S200) die zweiten Diagnosebänke bestimmt.

15. Batteriediagnoseverfahren nach Anspruch 13, wobei
der erste Fehlerdiagnoseschritt (S100) Folgendes enthält:
einen Schritt des Bestimmens (S110) eines ersten Referenzwiderstands (R1) und einer Widerstandsabweichung auf der Grundlage einer Vielzahl von ersten Innenwiderstandswerten in Bezug auf die Vielzahl von Batteriebänken (B1, B2, B3), und des Bestimmens einer ersten Widerstandszone auf der Grundlage des ersten Referenzwiderstands (R1) und der Widerstandsabweichung;
einen Schritt des Bestimmens (S130), als Zielbänke, einer Vielzahl von Batteriebänken mit Innenwiderstandswerten, die kleiner als der erste Referenzwiderstand (R1) sind, aus der Vielzahl von Batteriebänken (B1, B2, B3), und des Bestimmens eines zweiten Referenzwiderstands (R2) auf der Grundlage einer Vielzahl von zweiten Innenwiderstandswerten in Bezug auf die Vielzahl von Zielbänken, und des Bestimmens einer zweiten Widerstandszone auf der Grundlage des zweiten Referenzwiderstands (R2) und einer Parallelabweichung, die der Verbindungsstruktur der Vielzahl von Batteriezellen entspricht, die in jeder Zielbank enthalten sind; und
einen Schritt des Bestimmens der ersten Diagnosebänke und der Referenzbatteriebank durch Vergleichen des Innenwiderstandswerts jeder der Vielzahl von Batteriebänken (B1, B2, B3) mit der ersten Widerstandszone und der zweiten Widerstandszone.

16. Batteriediagnoseverfahren nach Anspruch 15, wobei
der Schritt des Bestimmens der ersten Widerstandszone Folgendes durchführt:
Bestimmen des Medianwerts der Vielzahl von ersten Innenwiderstandswerten als den ersten Referenzwiderstand (R1); und
Bestimmen einer absoluten Abweichung zwischen dem ersten Referenzwiderstand (R1) und dem Innenwiderstand der Vielzahl von einzelnen Batteriebänken, und Umwandeln der absoluten Abweichung in die Widerstandsabweichung unter Verwendung einer vorbestimmten Skalenkonstante.

17. Batteriediagnoseverfahren nach Anspruch 16, wobei
der Schritt des Bestimmens der ersten Widerstandszone eine erste obere Schwelle (U1) durch Addieren der Widerstandsabweichung zum ersten Referenzwiderstand (R1) bestimmt, und eine erste untere Schwelle (L1) durch Subtrahieren der Widerstandsabweichung vom ersten Referenzwiderstand (R1) bestimmt, und die erste Widerstandszone auf der Grundlage der ersten oberen Schwelle (U1) und der ersten unteren Schwelle (L1) bestimmt.

18. Batteriediagnoseverfahren nach Anspruch 15, wobei
der Schritt des Bestimmens der zweiten Widerstandszone Folgendes durchführt:
Bestimmen des Durchschnitts der Vielzahl von zweiten Innenwiderstandswerten als den zweiten Referenzwiderstand (R2); und
Bestimmen eines Parallelkoeffizienten auf der Grundlage der Anzahl von parallel geschalteten Batteriezellen, die in jeder Zielbank enthalten sind, und Bestimmen der Parallelabweichung durch Multiplizieren des Parallelkoeffizienten und des zweiten Referenzwiderstands (R2) miteinander.

19. Batteriediagnoseverfahren nach Anspruch 18, wobei
der Schritt des Bestimmens der zweiten Widerstandszone Folgendes durchführt:
Bestimmen einer zweiten oberen Schwelle (U2) durch Addieren der Parallelabweichung zum zweiten Referenzwiderstand (R2);
Bestimmen einer zweiten unteren Schwelle (L2) durch Subtrahieren der Parallelabweichung vom zweiten Referenzwiderstand (R2); und
Bestimmen der zweiten Widerstandszone auf der Grundlage der zweiten oberen Schwelle (U2) und der zweiten unteren Schwelle (L2).

## Revendications

1. Système de batterie (1) comprenant :
une batterie (10) qui inclut une pluralité de bancs de batteries (B1, B2, B3) dont chacun inclut une pluralité de cellules de batterie ; et
une unité de commande (23) qui détermine les rapports des deuxièmes quantités de changement d'état de charge des bancs de batteries (B1, B2, B3) par rapport à une première quantité de changement d'état de charge d'un banc de batteries de référence, et diagnostique les défauts des bancs de batteries (B1, B2, B3) en comparant les rapports à une valeur de référence de diagnostic, lorsqu'une condition de diagnostic prédéterminée est satisfaite dans un mode de charge consistant à charger la batterie (10) avec l'électricité d'un dispositif externe,
dans lequel la valeur de référence de diagnostic est déterminée sur la base du nombre de cellules de batterie connectées en parallèle dans un banc de batteries ;
dans lequel
la valeur de référence de diagnostic est déterminée par l'équation suivante : ${Th}_{1} = \frac{m}{m - n}$
où Th1 est une valeur de référence de diagnostic, et m est le nombre de cellules de batterie connectées en parallèle dans un banc de batteries, et n est un nombre naturel inférieur à m, où n est 1 ou 2.

2. Système de batterie selon la revendication 1, dans lequel
dans le mode de charge, lorsqu'une première condition de diagnostic selon laquelle au moins un banc de batteries doit atteindre un état de charge complète et une deuxième condition de diagnostic selon laquelle la quantité de changement d'état de charge de chacun de la pluralité de bancs de batteries (B1, B2, B3) doit être égale ou supérieure à une valeur de référence de condition sont satisfaites, l'unité de commande (23) diagnostique un défaut de la pluralité de bancs de batteries (B1, B2, B3).

3. Système de batterie selon la revendication 1, dans lequel
l'unité de commande (23) effectue les opérations suivantes :
déterminer une première résistance de référence (R1) et un écart de résistance (S) sur la base d'une pluralité de premières valeurs de résistance interne relatives à la pluralité de bancs de batteries (B1, B2, B3), et déterminer une première zone de résistance sur la base de la première résistance de référence (R1) et de l'écart de résistance (S) ;
déterminer, en tant que bancs cibles, une pluralité de bancs de batteries ayant des valeurs de résistance interne inférieures à la première résistance de référence (R1) parmi la pluralité de bancs de batteries (B1, B2, B3), et déterminer une deuxième résistance de référence (R2) sur la base d'une pluralité de deuxièmes valeurs de résistance interne relatives à la pluralité de bancs cibles (B1, B2, B3), et déterminer une deuxième zone de résistance sur la base de la deuxième résistance de référence et d'un écart parallèle correspondant à la structure de connexion de la pluralité de cellules de batterie incluses dans chaque banc cible ; et
déterminer, en tant que banc de batteries de référence, un banc de batteries ayant une valeur de résistance interne appartenant à la première zone de résistance et à la deuxième zone de résistance parmi la pluralité de bancs de batteries (B1, B2, B3).

4. Système de batterie selon la revendication 1, dans lequel l'unité de commande (23) est configurée pour :
déterminer des premiers bancs de diagnostic sur la base de la résistance interne de la pluralité de bancs de batteries (B1, B2, B3) ;
déterminer des deuxièmes bancs de diagnostic en comparant les rapports des deuxièmes quantités de changement d'état de charge des bancs de batteries à une première quantité de changement d'état de charge d'un banc de batteries de référence avec la valeur de référence de diagnostic, lorsqu'une condition de diagnostic prédéterminée est satisfaite dans un mode de charge consistant à charger la batterie avec l'électricité d'un dispositif externe, et
diagnostiquer, en tant que bancs de batteries défectueux, les bancs de batteries déterminés comme étant les premiers bancs de diagnostic et les deuxièmes bancs de diagnostic parmi la pluralité de bancs de batteries (B1, B2, B3).

5. Système de batterie selon la revendication 4, dans lequel
dans le mode de charge, lorsqu'une première condition de diagnostic selon laquelle au moins un banc de batteries doit atteindre un état de charge complète et une deuxième condition de diagnostic selon laquelle la quantité de changement d'état de charge de chacun de la pluralité de bancs de batteries (B1, B2, B3) doit être égale ou supérieure à une valeur de référence de condition sont satisfaites, l'unité de commande (23) détermine les deuxièmes bancs de diagnostic.

6. Système de batterie selon la revendication 4, dans lequel
l'unité de commande (23) effectue les opérations suivantes :
déterminer une première résistance de référence (R1) et un écart de résistance sur la base d'une pluralité de premières valeurs de résistance interne relatives à la pluralité de bancs de batteries (B1, B2, B3), et déterminer une première zone de résistance sur la base de la première résistance de référence (R1) et de l'écart de résistance ;
déterminer, en tant que bancs cibles, une pluralité de bancs de batteries ayant des valeurs de résistance interne inférieures à la première résistance de référence (R1) parmi la pluralité de bancs de batteries (B1, B2, B3), et déterminer une deuxième résistance de référence (R2) sur la base d'une pluralité de deuxièmes valeurs de résistance interne relatives à la pluralité de bancs cibles, et déterminer une deuxième zone de résistance sur la base de la deuxième résistance de référence (R2) et d'un écart parallèle correspondant à la structure de connexion de la pluralité de cellules de batterie incluses dans chaque banc cible ; et
déterminer, en tant que premier banc de diagnostic, un banc de batteries ayant une valeur de résistance interne qui est hors de la première zone de résistance ou de la deuxième zone de résistance parmi la pluralité de bancs de batteries (B1, B2, B3).

7. Système de batterie selon la revendication 5, dans lequel
l'unité de commande (23) détermine, en tant que banc de batteries de référence, un banc de batteries ayant une valeur de résistance interne appartenant à la première zone de résistance et à la deuxième zone de résistance parmi la pluralité de bancs de batteries (B1, B2, B3).

8. Système de batterie selon la revendication 6, dans lequel
l'unité de commande (23) effectue les opérations suivantes :
déterminer la valeur médiane de la pluralité de premières valeurs de résistance interne comme étant la première résistance de référence (R1) ; et
déterminer un écart absolu entre la première résistance de référence (R1) et la résistance interne de la pluralité de bancs de batteries individuels, et convertir l'écart absolu en écart de résistance, en utilisant une constante d'échelle prédéterminée.

9. Système de batterie selon la revendication 8, dans lequel
l'unité de commande (23) détermine un premier seuil supérieur (U1) en ajoutant l'écart de résistance à la première résistance de référence (R1), et détermine un premier seuil inférieur (L1) en soustrayant l'écart de résistance de la première résistance de référence (R1), et détermine la première zone de résistance sur la base du premier seuil supérieur (U1) et du premier seuil inférieur (L1).

10. Système de batterie selon la revendication 6, dans lequel
l'unité de commande (23) effectue les opérations suivantes :
déterminer la moyenne de la pluralité de deuxièmes valeurs de résistance interne comme étant la deuxième résistance de référence (R2) ; et
déterminer un coefficient parallèle sur la base du nombre de cellules de batterie connectées en parallèle incluses dans chaque banc cible, et déterminer l'écart parallèle en multipliant le coefficient parallèle par la deuxième résistance de référence (R2).

11. Système de batterie selon la revendication 10, dans lequel
l'unité de commande (23) effectue les opérations suivantes :
déterminer un deuxième seuil supérieur (U2) en ajoutant l'écart parallèle à la deuxième résistance de référence (R2) ;
déterminer un deuxième seuil inférieur (L2) en soustrayant l'écart parallèle de la deuxième résistance de référence (R2) ; et
déterminer la deuxième zone de résistance sur la base du deuxième seuil supérieur (U2) et du deuxième seuil inférieur (L2).

12. Système de batterie selon la revendication 4, comprenant en outre :
une unité de mesure (21) qui mesure une tension de banc qui est la tension entre les deux bornes de chacun de la pluralité de bancs de batteries (B1, B2, B3) et un courant de banc qui est le courant circulant à travers chacun de la pluralité de bancs de batteries (B1, B2, B3) ; et
une unité de stockage (22) qui stocke une valeur de résistance interne et un état de charge (SOC) qui est estimé sur la base d'au moins une de la tension de banc et du courant de banc.

13. Procédé de diagnostic des défauts d'une batterie incluant une pluralité de bancs de batteries dont chacun inclut une pluralité de cellules de batterie, comprenant :
une première étape de diagnostic de défaut (S100) consistant à déterminer des premiers bancs de diagnostic sur la base de la résistance interne de la pluralité de bancs de batteries (B1, B2, B3) ;
une deuxième étape de diagnostic de défaut (S200) consistant à déterminer des deuxièmes bancs de diagnostic en comparant les rapports des deuxièmes quantités de changement d'état de charge des bancs de batteries à une première quantité de changement d'état de charge d'un banc de batteries de référence avec une valeur de référence de diagnostic, lorsqu'une condition de diagnostic prédéterminée est satisfaite dans un mode de charge consistant à charger la batterie avec l'électricité d'un dispositif externe ; et
une étape de confirmation de diagnostic consistant à diagnostiquer, en tant que bancs de batteries défectueux, les bancs de batteries déterminés comme étant les premiers bancs de diagnostic et les deuxièmes bancs de diagnostic parmi la pluralité de bancs de batteries (B1, B2, B3),
dans lequel la valeur de référence de diagnostic est déterminée sur la base du nombre de cellules de batterie connectées en parallèle dans un banc de batteries ;
dans lequel
la valeur de référence de diagnostic est déterminée par l'équation suivante : ${Th}_{1} = \frac{m}{m - n}$
où Th1 est une valeur de référence de diagnostic, et m est le nombre de cellules de batterie connectées en parallèle dans un banc de batteries, et n est un nombre naturel inférieur à m, où n est 1 ou 2.

14. Procédé de diagnostic de batterie selon la revendication 13, dans lequel
dans le mode de charge, lorsqu'une première condition de diagnostic selon laquelle au moins un banc de batteries doit atteindre un état de charge complète et une deuxième condition de diagnostic selon laquelle la quantité de changement d'état de charge de chacun de la pluralité de bancs de batteries (B1, B2, B3) doit être égale ou supérieure à une valeur de référence de condition sont satisfaites, la deuxième étape de diagnostic de défaut (S200) détermine les deuxièmes bancs de diagnostic.

15. Procédé de diagnostic de batterie selon la revendication 13, dans lequel
la première étape de diagnostic de défaut (S100) inclut :
une étape consistant à déterminer (S110) une première résistance de référence (R1) et un écart de résistance sur la base d'une pluralité de premières valeurs de résistance interne relatives à la pluralité de bancs de batteries (B1, B2, B3), et à déterminer une première zone de résistance sur la base de la première résistance de référence (R1) et de l'écart de résistance ;
une étape consistant à déterminer (S130), en tant que bancs cibles, une pluralité de bancs de batteries ayant des valeurs de résistance interne inférieures à la première résistance de référence (R1) parmi la pluralité de bancs de batteries (B1, B2, B3), et à déterminer une deuxième résistance de référence (R2) sur la base d'une pluralité de deuxièmes valeurs de résistance interne relatives à la pluralité de bancs cibles, et à déterminer une deuxième zone de résistance sur la base de la deuxième résistance de référence (R2) et d'un écart parallèle correspondant à la structure de connexion de la pluralité de cellules de batterie incluses dans chaque banc cible ; et
une étape consistant à déterminer les premiers bancs de diagnostic et le banc de batteries de référence en comparant la valeur de résistance interne de chacun de la pluralité de bancs de batteries (B1, B2, B3) avec la première zone de résistance et la deuxième zone de résistance.

16. Procédé de diagnostic de batterie selon la revendication 15, dans lequel
l'étape de détermination de la première zone de résistance effectue les opérations suivantes :
déterminer la valeur médiane de la pluralité de premières valeurs de résistance interne comme étant la première résistance de référence (R1) ; et
déterminer un écart absolu entre la première résistance de référence (R1) et la résistance interne de la pluralité de bancs de batteries individuels, et convertir l'écart absolu en écart de résistance, en utilisant une constante d'échelle prédéterminée.

17. Procédé de diagnostic de batterie selon la revendication 16, dans lequel
l'étape de détermination de la première zone de résistance détermine un premier seuil supérieur (U1) en ajoutant l'écart de résistance à la première résistance de référence (R1), et détermine un premier seuil inférieur (L1) en soustrayant l'écart de résistance de la première résistance de référence (R1), et détermine la première zone de résistance sur la base du premier seuil supérieur (U1) et du premier seuil inférieur (L1).

18. Procédé de diagnostic de batterie selon la revendication 15, dans lequel
l'étape de détermination de la deuxième zone de résistance effectue les opérations suivantes :
déterminer la moyenne de la pluralité de deuxièmes valeurs de résistance interne comme étant la deuxième résistance de référence (R2) ; et
déterminer un coefficient parallèle sur la base du nombre de cellules de batterie connectées en parallèle incluses dans chaque banc cible, et déterminer l'écart parallèle en multipliant le coefficient parallèle par la deuxième résistance de référence (R2).

19. Procédé de diagnostic de batterie selon la revendication 18, dans lequel
l'étape de détermination de la deuxième zone de résistance effectue les opérations suivantes :
déterminer un deuxième seuil supérieur (U2) en ajoutant l'écart parallèle à la deuxième résistance de référence (R2) ;
déterminer un deuxième seuil inférieur (L2) en soustrayant l'écart parallèle de la deuxième résistance de référence (R2) ; et
déterminer la deuxième zone de résistance sur la base du deuxième seuil supérieur (U2) et du deuxième seuil inférieur (L2).
